# EUROPEAN PATENT SPECIFICATION

(11) **EP 0 992 100 B1**
(45) Date of publication and mention of the grant of the patent: **25.04.2007**
(21) Application number: 98931856.3
(22) Date of filing: 03.07.1998
(51) Int. Cl.: H02J 7/00, G01R 31/36

(54) **SYSTEM AND METHOD FOR MANAGEMENT OF BATTERY BACK UP POWER SOURCE**
EINRICHTUNG UND METHODE FÜR DIE VERWALTUNG EINER BATTERIENOTSTROMVERSORGUNGSEINRICHTUNG
SYSTEME ET METHODE DE GESTION D'UNE SOURCE D'ENERGIE DE BATTERIE DE SECOURS

(30) Priority: 03.07.1997 US 887844; 04.07.1997 CA 2209817
(43) Date of publication of application: 12.04.2000
(73) Proprietor: R.V. Holdings Corp. in Trust, Ottawa ON K2C 0R3 (CA)
(72) Inventor: DUNN, James, H., Limoges, Ontario K0A 2M0 (CA); de OLIVEIRA, Julio, C., Gloucester, Ontario K1W 1G8 (CA); GERWING, David, H., Greely, Ontario K4P 1A6 (CA)
(74) Representative: Gerbaulet, Hannes
(86) International application number: PCT/CA1998/000650
(87) International publication number: WO 1999/001918

(56) References cited:
- EP-A- 0 348 839
- WO-A-97/28574
- US-A- 4 484 140
- US-A- 4 707 795
- US-A- 5 153 496
- US-A- 5 543 245

## Description

### BACKGROUND TO THE INVENTION

The present invention relates to a system and method for the management of a battery pack used as a power back-up for an A.C. power source. The invention has particular application to distributed telecommunication systems and enables the useful capacity and health of a back-up battery power source of one or more of the links in the telecom system to be monitored, assessed and managed from a remote location.

The invention may be used in conjunction with any device or network of devices which is battery-powered, or which uses a battery pack as an alternative or back-up power source, such as telecommunication relay sites, fibre optic sites, computers; telecommunication or station batteries; telephone switching facilities and portable test equipment.

Other potential applications include railway crossing and switch systems; mobile electronic equipment battery packs used in cellular telephones, computers, camcorders or electric vehicles.

There is presently no fully reliable and accurate means for determining the useful capacity of batteries, e.g. those used as a back up for a primary AC power source for an instrument or device which is situated at a remote location. In the event of an AC power failure, it is essential that the DC battery back-up power operate efficiently and at the required capacity. To date, there has been no practical method to load test a back-up battery at a remote site. Conventional devices measure voltage, impedance, electrolyte specific gravity or other battery characteristics, but do not provide the user with direct information concerning the length of time the battery will operate under load.

Regarding the prior art, one of these is US Patent 4,707,795, issued to Alber at al. Alber et al provides a battery and monitoring system specifically designated to continuously monitor overall battery voltage, conditions of individual cells or cell groups such as voltage, current and temperature as well as individual cell or cell group failures. This system also is designed continuously monitor conduction path failures and other conditions. The system is a portable or permanently installed unit having connectable thereto a programming/display/printer terminal which enables the programming of the monitor with various failure conditions as desired. This terminal also enables the printing of a permanent record of any testing procedure. Furthermore, portable load units can be interconnected with the monitor and the battery or batteries which are currently being tested and monitored so as to enable the testing and/or monitoring of such battery or batteries under controlled load conditions.

Another piece of prior art is US Patent 5,153,496 issued to LaForge. This patent discloses a cell monitoring and control circuit for a multicell battery. The circuit comprises a cell access switch coupled to the cells of the battery for electronically accessing individual cells of the battery. The circuit also includes a monitoring and control circuit coupled to the cell access switch for electronic communication with the cells. The circuit is coupled to the battery for providing electric power and constitutes an insignificant current drain on the battery. The circuit senses the voltage state of each cell and controls the charging of each cell and provides End-of-Discharge and End-of-Charge signals.

Another piece of prior art is US Patent 5,543,245 issued to Andrieu et al. This patent discloses a system for monitoring aging of a battery comprising a plurality of cells connected in series and able to be fully discharged. The system comprises a plurality or dischargers which discharge respective ones of the previously charged cells to an end of discharge value. The quantity of electricity supplied by at least one discharged cell is processed to detect excessive aging of the battery. Excessive aging of the battery results in a residual capacity which is less than a fraction of the nominal capacity of the battery.

However, none of the above-discussed prior art documents teaches to measure the discharge current and/or the charge current of the battery cell or module, for example for calculating the useful capacity of the respective cell or module. This can result in highly damaging conditions in the discharged cell or module, and overcharging the other cells or modules in the battery, adversely affecting the cell or module life.

### SUMMARY OF THE INVENTION

The present invention obviates and mitigates the disadvantages inherent in the prior art by providing a system according to claim 1 as well as a method according to claim 10 for directly assessing the useful capacity of a back-up battery, even where the battery is located at a remote site and without compromising the ability of the back-up battery to operate should there be an AC power failure during the battery testing.

This objective is achieved by performing a sequential, individual assessment of each module which comprises a battery pack, wherein the provision of current measurement means for measuring a discharge current and/or a charge current of the battery module(s) enables the calculating of data with respect to the useful capacity of the battery module(s) based on the current of the battery module(s). Where used in this specification, the term "module" means one or more electrochemical cells.

A further advantage of the present invention arises from its capability to rejuvenate or boost the health of the battery module of certain chemistries, e.g. valve regulated lead acid (VRLA) or nickel/cadmium. The discharge/charge sequence which is carried out in order to assess and monitor the useful capacity of the module, also serves to better cycle the module.

The method according to the present invention enables managing the back-up, battery power source of the distributed communications systems of the telecommunications industry. The invention enables individual telecom sites with fibre optic or radio equipment powered by systems containing back-up batteries to be operated with improved reliability and economy. The invention provides smart charging at the cell or module level, thus ensuring that the back-up battery pack always receives optimum charging. The invention further provides a continuously updated battery pack capacity based on cell or module discharge tests so that the individual sites on the telecom system are provided with a real time method of back-up battery network management. This network battery management system provides the user with information to optimize the efficiency and operability of the telecom system, in case of AC power failure, particularly if there is a widespread or prolonged AC power outage.

In one aspect (cf. claim 1), the invention provides a system
- for directly assessing the useful capacity of at least one battery module in a battery pack, and/or
- for cycling battery modules in a battery pack while the battery pack remains in service, and/or
- for battery health management of, in particular remotely situated back up, battery packs, the system comprising:
- a monitor circuit being operatively connected to a programmable logic controller and to one or more battery modules in the battery pack, the monitor circuit comprising
   -- battery module charging means,
   -- discharge load means, in particular discharging means for discharging the battery module, and
   -- at least one current measurement means for measuring a discharge current and/or a charge current of the at least one battery module;
- the programmable logic controller for calculating the useful capacity of the battery module based on the current of the at least one battery module; and
- a plurality of relays being controlled by the programmable logic controller and being connected between the monitor circuit and the battery pack, in particular being coupled between the battery module charging means, the discharge load means, and the battery modules,
   the programmable logic controller
- being designed for controlling the battery module charging means and the discharge load means and
- selectively, and in particular sequentially, opening and closing the plurality of relays, which connect with the battery module charging means and the discharge load means,
   -- to couple at least one battery module in the battery pack to the battery module charging means or to the discharging means and/or
   -- to alternatively define a discharge circuit which enables one of the modules to be discharged by the discharge load means, in particular under a predefined load, and/or to be recharged by said battery module charging means.

Preferably, the programmable logic controller comprises, or is operatively connected to at least one module voltage reader;
battery pack current reader and module current reader; a switch controller to control said isolation relays; a controller for said variable discharge load means and said single module battery charger (charger/discharger controller).

In an additional aspect (cf. claim 10), the invention provides a method of sequentially assessing the operating capacity or useful capacity of a plurality of battery modules which define a battery pack, the method comprising the steps of:
- providing a programmable logic controller including a controller to control the opening and closing of relays;
- selecting one of said modules for assessment;
- connecting said selected module to a variable discharge load means by closing said relays which connect said module to said variable discharge load means;
- measuring current parameters which define the useful capacity of said module, while said module is under load;
- determining whether said useful capacity meets a predefined threshold for useful capacity;
- disconnecting said selected module from said variable discharge load means by opening said relays and either
   (a) connecting said selected module to a battery module charging means for recharging where said useful capacity meets said predefined threshold or
   (b) generating a signal where said useful capacity does not meet said predefined threshold;
      wherein the coordination of all of the above steps is accomplished by the use of said programmable logic controller operatively comprising, in combination,
- at least one voltage reader;
- at least one battery current reader; and
- at least one module current reader.

Preferably, the useful capacity is enhanced and/or the rate of capacity loss of the battery packs is reduced during service by using an optimal recharge method on the battery modules which comprise said battery pack while said battery pack remains in service; in particular, the plurality of different recharge methods can be chosen from the group comprising:
a) constant voltage;
b) constant current;
c) constant power;
d) fast charge;
e) pulse charging.

### BRIEF DESCRIPTION OF THE DRAWINGS

Figure 1 is a schematic drawing of a preferred embodiment of the invention, depicting a bridged connection circuit with three modules;
Figure 2 is a schematic drawing of a further preferred embodiment of the invention, depicting a bridged connection circuit with "n" modules;
Figure 3 is a flowchart, schematically depicting operation of the present invention;
Figure 4 is a schematic representation of the network management system, being a further embodiment of the invention
Figure 5 is a schematic representation of an enhanced battery management network, being a further embodiment of the invention
Figure 6 is a schematic drawing of an optional inserted connection circuit

### DESCRIPTION OF THE PREFERRED EMBODIMENT

The device of the present invention comprises a programmable logic controller (PLC) or computer, coupled to a plurality of multi-pole contactors, relays or solid state switching devices.

The device of the present invention may be used in conjunction with rechargeable batteries of various chemical composition(s). Some are sealed, others are flooded while others are valve-regulated batteries. The typical chemistry of the batteries is nickel/cadmium or lead-acid. The threshold voltage is established having regard to the chemistry of the module.

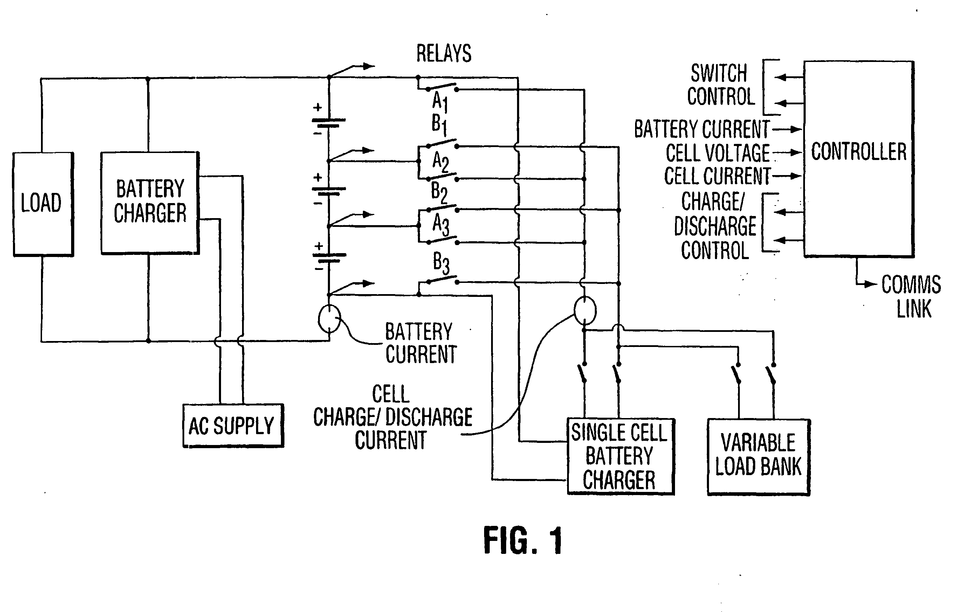

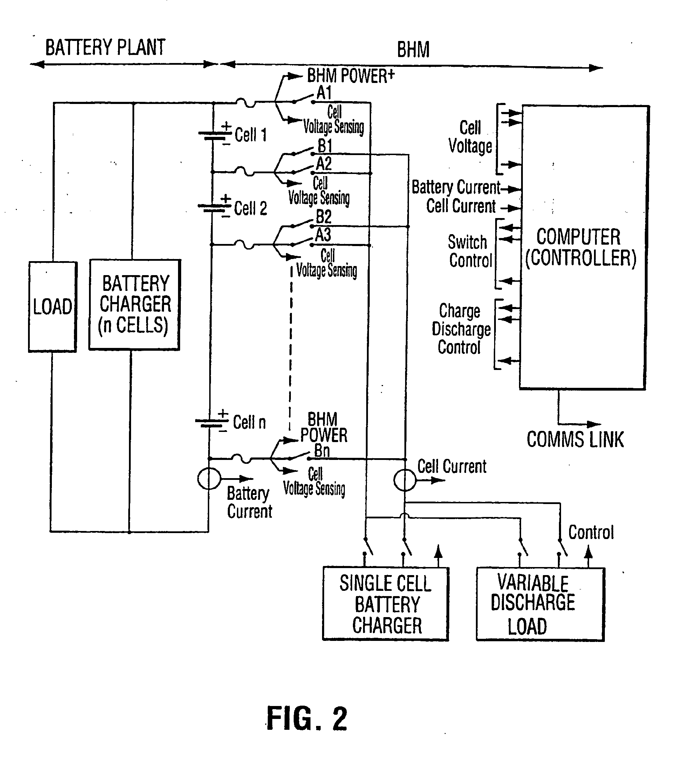

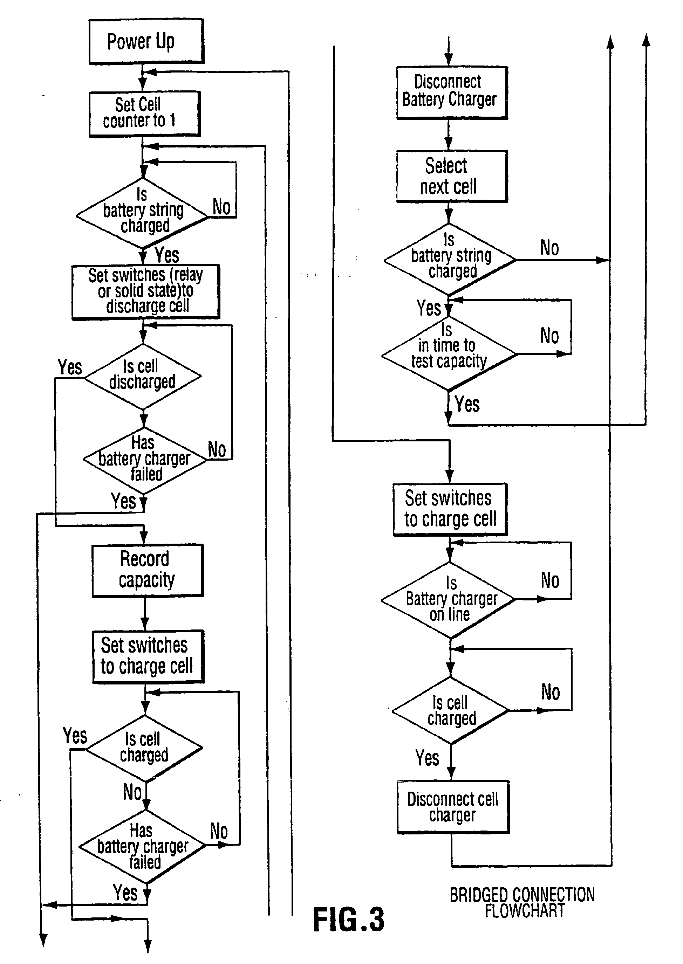

The invention makes use of a bridged connection circuit, which uses the principle of Kirchoff's law. Such an approach means that the module which is being assessed need not be isolated from the other modules comprising the battery pack. Figures 1 and 2 schematically represent a bridged connection. A bridged circuit ensures that the electrical integrity of the battery pack does not have to be broken in order to assess a single module. Using the algorithm outlined in Figure 3, the capacity of each module is sequentially calculated. The computer controls the opening and closing of isolation relays, the variable discharge load, as well as the module battery charger. Further the computer senses the following: battery pack string current and voltage, selected module charge/discharge current, selected module voltage, ambient temperature, and battery pack and/or module temperatures.

In Figure 2, the battery pack is shown as operatively connected to a circuit comprising a load and a battery charger which represents the primary power source and load for which the battery pack is intended to provide back up. In order for the operative capacity of the back-up battery pack to be accurately measured, an allowance must be made for the current which flows from the primary power source into the battery pack. Use of Kirchoff's law, where +/- ic = +/- ip + +/- im where +/- is positive for charge and negative for discharge, ic is module current, ip is current of the primary power circuit, and im is the current of the monitor device, enables the PLC to accurately and selectively measure the operative capacity of a given module within the battery pack without isolating or disengaging the module from the other modules which comprise the battery pack.

In operation, the controller selectively controls and coordinates the opening and closing of the switches which connect the battery charger and the variable discharge load. Where it is desired to measure the capacity of module or cell 1, isolation relays A1 and B1 are closed by command of the PLC, which then closes the relays which connect the variable discharge load with the battery. The discharge circuit which is thus created enables module or cell 1 to be discharged across the variable discharge load. Module current is measured by a reader within the circuit and fed back to the PLC. The PLC then causes the relays connecting the variable discharge load to the battery to open, and then closes the relays which connect the battery charger with the battery, thereby defining a charging circuit which recharges module 1 up to a threshold level which is consistent with the useful capacity of the other modules within the string. The procedure is then sequentially repeated for the remaining modules 2, 3,....n within the string.

The programmable logic controller comprises, or is connected to at least one module voltage reader; at least one battery pack current reader and module current reader; a switch controller to control the isolation relays; a controller for said variable discharge load means and said single module battery charger (charger/discharger controller).

Both the variable discharge load and battery charger output are adjusted according to the ambient battery and module temperature present to prevent battery damage. As well, the computer calculates the a-h (ampere-hour) capacity of each battery cell by integrating the discharge current over the time taken to reach the cut-off voltage threshold, or the energy capacity by the above integration of current times voltage over discharge time in hours. An alternative to using computer control of the variable discharge load and battery charger is direct control using linear circuits.

The means used to discharge the module may be a use specific variable discharge profile, constant current, constant resistance, or constant power. The method chosen will depend on the battery technology and the normal usage. To implement these methods, a variable resistor or the like is typically used.

The battery charger used to recharge the module under scrutiny may operate with a variety of algorithms including constant voltage/current, constant power and fast charge methods, including pulse charging.

In another preferred embodiment, relays A, B and C shown in Figures 2 and 3 may be replaced with solid state switches. However, solid state devices have the following characteristics which affect their suitability as replacements for relays:
1) They tend to have a voltage drop when conducting current. In the inserted connection embodiment, the battery voltage under load would be reduced somewhat (a fraction of a volt). In the case of the bridged connection, this problem could be reduced by sensing battery voltages at the connection to the invention;
2) Usually, two such solid state devices are needed for conducting in two directions. This increases the cost and complexity of the design;
3) Inputs are not isolated from outputs. This is somewhat problematic, since the monitor circuit needs to connect to points up and down the chain of modules making up the battery. If the battery voltage exceeds 30 volts, optical isolation is needed which further complicates the design.

Because of the problems outlined above, the use of solid state switches as replacements for relays A, B and C would be determined on a case by case basis. The most likely applications would be for batteries having voltages below 30 volts or with currents below a few amperes, or where the battery power levels are not much larger than the relay drive requirements or where the use of electromechanical relays is undesirable for other reasons.

The invention works as an integral part of the battery and is designed to continue to operate in the event of an AC power failure, and is able to provide a full load current to substitute for a partially discharged module. This ensures that the useful capacity of the battery pack is available and that the module is protected from reverse-voltage damage.

So that no capacity is lost in the unlikely event of the module battery charger failing when the isolated battery is discharged, extra capacity is provided in the form of an external module. This module will normally be float charged by the invention. When the battery charger fails during a discharge cycle, the external module or battery will be used to power the battery charger.

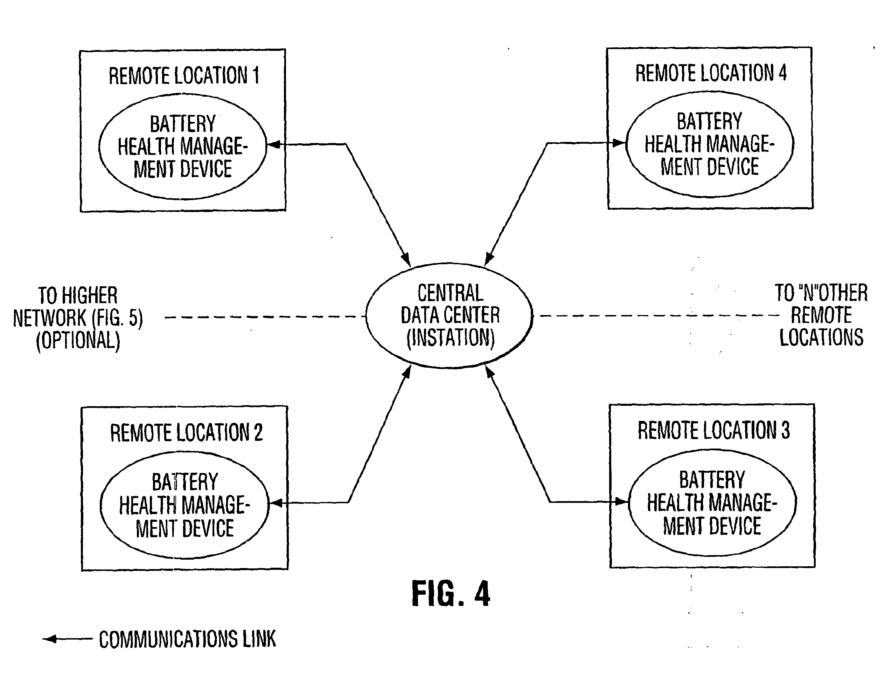

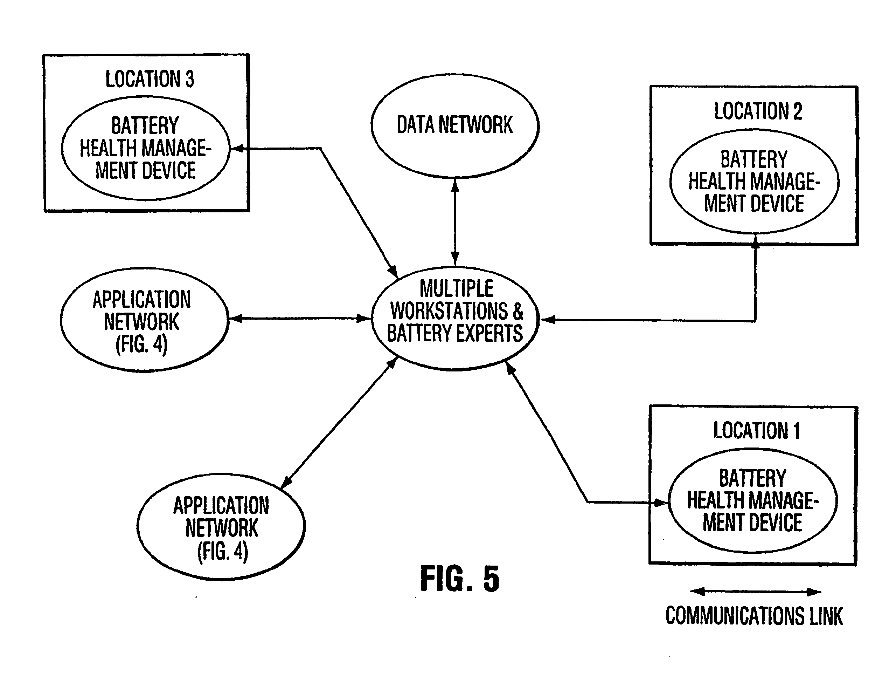

The device of the present invention may further comprise an alarm circuit which conveys an audible or visible warning signal that the capacity of the battery pack has fallen below useful level, which is particularly important where the battery pack is being used as a back-up power source. This provides the: option of replacing individual batteries from the battery instead of the whole pack, thereby providing a substantial increase in battery pack life and a resulting decrease in battery cost to the user.
As depicted by Figure 4, a plurality of the devices of the present invention may be networked to permit the gathering of data required for the effective management of systems with multiple battery installations. The data collected from the network is collated in one central data center. This eases the problem of handling a large amount of data, enables the analysis of standby power in large, complex systems, which facilitates the making of rapid, well-informed decisions.

The embodiment shown in Figure 4 is a network of a plurality battery health management devices (shown in Figures 1 or 2 herein) installed in conjunction with the battery back up power sources for multiple, remote installations at sites on a telecommunications or other similar network or system. The remote battery health management devices are linked by multiple communications or sub-networks to one or more instations. The instation is equipped with suitable software to enable the instation to log data from the remote installations, generates alarms, produce statistics, group data in tables for comparison, plot trends, extrapolate data generate reports and assist in record keeping.

The network shown in Figure 4 is application specific and focuses on assisting in the routine health management (including monitoring or power outages) of a remote battery, such as remote cellular site. Because of the emphasis on routine maintenance, the instation presents information such as battery back time remaining, alarms, maintenance records, site down time and power outages records. The system is equipped with extensive database facilities that are used for trending or to provide historical evidence of battery system status.

A more sophisticated type of network is depicted in Figure 5 which comprises a plurality of individual battery health management installations and/or one or more application specific networks. All of the data collected at the individual installations or sites on this network are collated at a master control center which is equipped to manage battery maintenance of individual sites or systems by providing routine monitoring, and/or diagnostic assistance. The master control center may be staffed with personnel who are well acquainted with battery systems and maintenance and who are able to analyse problems as reflected by the incoming data, and who can further provide and implement constructive and remedial advice.

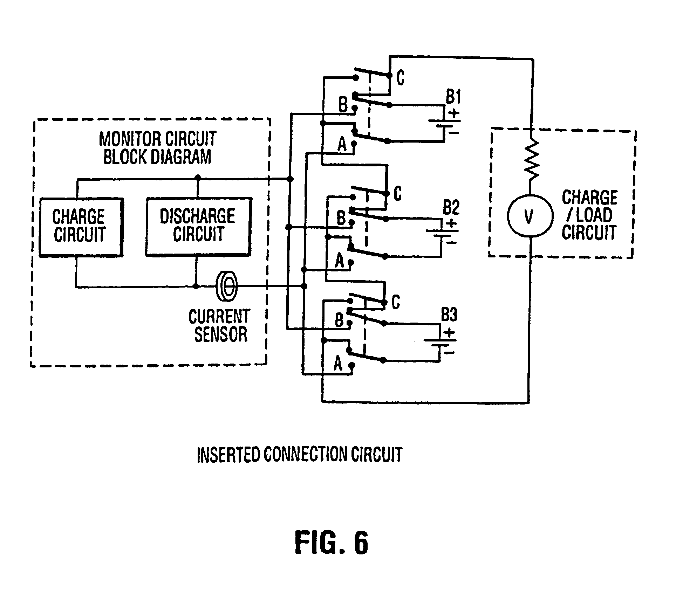

Optionally, a battery health management device shown as sites in the networks depicted in Figures 4 and 5 may use an inserted connection circuit, shown in Figure 6, in place of the bridged connection circuit shown in Figures 1 and 2.

An inserted connection circuit isolates one of the multiple modules in the battery pack (typically nine or eleven modules) by taking the cell out of the trickle/float charge circuit and then performing a discharge of the battery module which drains the energy of the module into variable discharge means such as a fixed resistance heater or similar device at the normal rated load capacity for that module. The PLC then records which module is being discharged, and how long it takes to discharge to a pre-programmed cut-off voltage. This information is then used to calculate how much energy the module was able to deliver under actual loaded conditions, thereby providing a real measure of its useful capacity. The information on module capacity is provided by way of a liquid crystal display, or similar means, and is given in watt-hours, ampere-hours; % of "as new" or the time to failure under load in minutes, whichever is required by the end user. When the measured capacity falls below a predefined threshold an alarm will be triggered, signalling the need for battery or module replacement. The battery module charger will be engaged to recharge the discharged module.

In the inserted connection circuit shown in Figure 6, batteries B1, B2 and B3 operate a charge/load circuit V. Isolation relays or contacts A and B connect an individual module to a monitor circuit, while contact C closes the gap in the battery created by the removal of the module. When relay contact C is closed, the open circuit formed by the removal of the battery module is closed, thereby allowing current to flow through the charge/ load circuit. When isolation relays A, B are closed, an individual battery module can be isolated and connected to the monitor circuit. The monitor circuit discharges the isolated battery module and charges it as required using feedback provided by the current sensor and the preset voltage limits.

In the event of an AC mains failure, the relays must continue to operate, otherwise a discharged module would be reintroduced into the battery pack, reducing the useful capacity of the battery pack.

The battery voltage would normally be (Vc * N-1) where Vc is the nominal module voltage and N is the number of modules in the battery. As the monitor circuit moves from one module to the next, it causes a disruption in the battery pack voltage. The battery pack momentarily goes open-circuit, then the voltage Jumps to Vc* N, then the battery pack goes open-circuit again, then finally the voltage returns to (Vc * N-1).

The module to be measured is accordingly isolated from the other modules comprising the battery pack by the selective engagement of isolation relays. The module is then discharged, its capacity is measured by the PLC as a function of the discharge load, and it is then recharged. The isolated module is temporarily unable to contribute to the output of the battery. The procedure is sequentially repeated, at selectable times, for the remaining modules which comprise the battery pack.

Only one battery module at a time is discharged so that the system is never more than 1/9 or 11% short of its maximum ampere-hour or watt-hour energy capacity (in the case of a nine cell battery pack). In the event of an AC power outage (i.e. a situation where the DC battery pack is engaged), when one of the modules is not fully charged, this module is kept out of the circuit by the use of isolation relays.

As an alternative to this method, an identical module to the battery modules in the battery pack can be added to the battery pack; for example, making a 9 module battery pack into a 10 module battery pack. In this case, the module battery charger will be powered from the battery pack.

In the event that there is a battery module with less useful capacity than the other modules in the pack, the invention can assess the state of health of the reduced capacity module and electrically isolate it from the rest of the battery pack, until such time as the rest of the pack has a poorer performing module than the isolated, reduced capacity module.

## Claims

1. A system
- for directly assessing the useful capacity of at least one battery module in a battery pack, and/or
- for cycling battery modules in a battery pack while the battery pack remains in service, and/or
- for battery health management of, in particular remotely situated back up, battery packs, the system comprising:
- a monitor circuit being operatively connected to a programmable logic controller and to one or more battery modules in the battery pack, the monitor circuit comprising
-- battery module charging means,
-- discharge load means, in particular discharging means for discharging the battery module, and
-- at least one current measurement means for measuring a discharge current and/or a charge current of the at least one battery module;
- the programmable logic controller for calculating data with respect to the useful capacity of the battery module based on the current of the at least one battery module; and
- a plurality of relays being controlled by the programmable logic controller and being connected between the monitor circuit and the battery pack, in particular being coupled between the battery module charging means, the discharge load means, and the battery modules,
the programmable logic controller
- being designed for controlling the battery module charging means and the discharge load means and
- selectively, and in particular sequentially, opening and closing the plurality of relays, which connect with the battery module charging means and the discharge load means,
-- to couple at least one battery module in the battery pack to the battery module charging means or to the discharging means and/or
-- to alternatively define a discharge circuit which enables one of the modules to be discharged by the discharge load means and to be recharged by said battery module charging means.

2. The system according to claim 1, wherein
- said programmable logic controller is connected by a communications link to a data center which collates and processes data transmitted by said programmable logic controller, and
- data with respect to the useful capacity of the battery module is calculated by said programmable logic controller and is transmitted to said data center.

3. The system according to claim 1 or 2, further comprising means for recording of said data calculated by said programmable logic controller.

4. The system according to at least one of claims 1 to 3, wherein said relays are selected from the group consisting of multi-pole relays, contactors or solid state switching devices.

5. The system according to at least one of claims 1 to 4, wherein the discharge load means for discharging the at least one battery module further includes means for discharging the at least one battery module under a predefined load.

6. The system according to at least one of claims 1 to 5, wherein the discharge load means for discharging the at least one battery module further includes means for variably discharging the at least one battery module.

7. The system according to at least one of claims 1 to 6, wherein the programmable logic controller includes:
- a switch controller to control the plurality of relays;
- a controller for the discharge load means; and
- a controller for the battery module charging means.

8. The system according to at least one of claims 1 to 7, wherein the data center is a master control center which provides a plurality of services including routine monitoring and diagnostic assistance.

9. The system according to at least one of claims 1 to 8, **characterized by** enhancing the useful capacity and/or reducing the rate of capacity loss of the battery pack during service by using an optimal recharge method on the battery module which comprises said battery pack while said battery pack remains in service, wherein the plurality of different recharge methods are chosen from the group comprising:
a) constant voltage;
b) constant current;
c) constant power;
d) fast charge;
e) pulse charging.

10. A method of sequentially assessing the useful capacity of a plurality of battery modules which define a battery pack, the method comprising the steps of:
- providing a programmable logic controller including a controller to control the opening and closing of relays;
- selecting one of said modules for assessment;
- connecting said selected module to a variable discharge load means by closing said relays which connect said module to said variable discharge load means;
- measuring current parameters which define the useful capacity of said module, while said module is under load;
- determining whether said useful capacity meets a predefined threshold for useful capacity;
- disconnecting said selected module from said variable discharge load means by opening said relays and
either recharging said selected module by connecting said selected module to a battery module charging means where said useful capacity meets said predefined threshold
or generating a signal where said useful capacity does not meet said predefined threshold;
wherein
- the above steps are coordinated by said programmable logic controller operatively comprising, in combination,
-- at least one voltage reader;
-- at least one battery current reader; and
-- at least one module current reader.

11. The method according to claim 10, wherein the discharge load means discharges the selected module under a predefined ioad.

12. The method according to claim 10 or 11, wherein the discharge load means discharges the selected module under variable loads.

13. The method according to at least one of claims 10 to 12, further including recording capacity data regarding the useful capacity of the selected module.

14. The method according to at least one of claims 10 to 13, further including determining a capacity of other modules in the battery pack from recorded capacity data of other modules in the battery pack and recharging the selected module by connecting the selected module to the battery module charging means, the selected module being recharged to a recharge level consistent with the capacity of other modules in the battery pack.

15. The method according to at least one of claims 10 to 14, wherein the discharging means discharges the at least one battery module under a predefined load.

16. The method according to at least one of claims 10 to 15, wherein the discharging means discharges the at least one battery module under variable loads.

## Patentansprüche

1. System
- zur direkten Bestimmung der nutzbaren Kapazität mindestens eines Batteriemoduls in einem Batteriesatz, und/oder
- zum Durchlaufen von Batteriemodulen in einem Batteriesatz, während der Batteriesatz in Betrieb bleibt, und/oder
- zur Batteriezustandspflege von insbesondere fern angeordneten Reservebatteriesätzen,
wobei das System umfasst:
- eine Kontrollschaltung, die mit einem Steuergerät mit programmierbarer Logik funktionsfähig verbunden ist und mit einem oder mehreren Batteriemodulen im Batteriesatz, wobei die Kontrollschaltung umfasst
-- Batteriemodullademittel,
-- Entladungsmittel, insbesondere Entladungsmittel zum Entladen des Batteriemoduls, und
-- mindestens ein Strommessmittel zur Messung eines Entladungsstromes und/oder eines Ladestromes des mindestens einen Batteriemoduls,
- das Steuergerät mit programmierbarer Logik zur Berechnung von Daten mit Bezug auf die nützliche Kapazität des Batteriemoduls aus dem Strom des mindestens einen Batteriemoduls, und
- mehrere Relais, die vom Steuergerät mit programmierbarer Logik gesteuert werden und zwischen die Kontrollschaltung und den Batteriesatz geschaltet sind und insbesondere zwischen dem Batteriemodullademittel, dem Entladungsmittel und den Batteriemodulen angeschlossen sind,
wobei das Steuergerät mit programmierbarer Logik dafür entworfen ist,
- die Batteriemodullademittel zu kontrollieren und die Entladungsmittel, und
- wahlweise und insbesondere aufeinanderfolgend die mehreren Relais zu öffnen und zu schließen, die mit den Batteriemodullademitteln und den Entladungsmitteln verbinden,
-- um mindestens ein Batteriemodul im Batteriesatz an das Batteriemodullademittel anzuschließen oder an das Entladungsmittel und/oder
-- alternativ eine Entladungsschaltung festzulegen, die ermöglicht, eins der Module durch die Entladungsmittel zu entladen und durch die genannten Batteriemodullademittel wieder aufzuladen.

2. System gemäß Anspruch 1, in dem
- das genannte Steuergerät mit programmierbarer Logik durch eine Kommunikationsverbindung mit einem Datenzentrum verbunden ist, das Daten zusammenstellt und verarbeitet, die durch das genannte Steuergerät mit programmierbarer Logik übertragen werden, und
- Daten mit Bezug auf die nutzbare Kapazität des Batteriemoduls durch das genannte Steuergerät mit programmierbarer Logik berechnet und an das genannte Datenzentrum übertragen werden.

3. System gemäß Anspruch 1 oder 2, außerdem Mittel zur Speicherung der genannten Daten, die vom genannten Steuergerät mit programmierbarer Logik berechnet werden, umfassend.

4. System gemäß mindestens einem der Ansprüche 1 bis 3, in dem die genannten Relais aus der Gruppe ausgewählt sind, die aus Mehrfachrelais, Schützen oder Festkörperschaltvorrichtungen besteht.

5. System gemäß mindestens einem der Ansprüche 1 bis 4, in dem das Entladungsmittel zur Entladung des mindestens einen Batteriemoduls außerdem Mittel zur Entladung des mindestens einen Batteriemoduls unter eine festgelegte Ladung umfasst.

6. System gemäß mindestens einem der Ansprüche 1 bis 5, in dem das Entladungsmittel zur Entladung des mindestens einen Batteriemoduls außerdem Mittel zur variablen Entladung des mindestens einen Batteriemoduls umfasst.

7. System gemäß mindestens einem der Ansprüche 1 bis 6, in dem das Steuergerät mit programmierbarer Logik umfasst:
- eine Schalterbetätigungseinrichtung zur Steuerung der mehreren Relais,
- eine Regeleinrichtung für das Entladungsmittel, und
- eine Regeleinrichtung für das Batteriemodullademittel.

8. System gemäß mindestens einem der Ansprüche 1 bis 7, in dem das Datenzentrum ein Hauptsteuerungszentrum ist, das mehrere Dienstleistungen liefert, einschließlich Routinekontroll- und Diagnosehilfe.

9. System gemäß mindestens einem der Ansprüche 1 bis 8, **gekennzeichnet durch** Erhöhung der nutzbaren Kapazität und/oder Verringerung der Kapazitätsverlustrate des Batteriesatzes im Betrieb **durch** Anwendung eines optimalen Ladeverfahrens auf das Batteriemodul, das im genannten Batteriesatz enthalten ist, während der genannte Batteriesatz im Betrieb bleibt, wobei die mehreren verschiedenen Ladeverfahren aus der Gruppe ausgewählt werden, die umfasst:
a) mit konstanter Spannung,
b) mit konstantem Strom,
c) mit konstanter Leistung
d) Schnellladung,
e) Pulsladung.

10. Verfahren zur Abschätzung der nutzbaren Kapazität mehrerer Batteriemodule, die einen Batteriesatz bilden, nacheinander, wobei das Verfahren die folgenden Schritte umfasst:
- Bereitstellung eines Steuergerätes mit einer Betätigungseinrichtung zur Steuerung des Öffnens und Schließens von Relais,
- Auswahl eines der genannten Module für die Abschätzung,
- Verbindung des genannten ausgewählten Moduls mit einem Mittel zur variablen Entladung durch Schließen des genannten Relais, das das genannte Modul mit dem genannten Mittel zur variablen Entladung verbindet,
- Messung von Stromparametern, die die nutzbare Kapazität des genannten Moduls bestimmen, während das genannte Modul geladen ist,
- Feststellen, ob die genannte nutzbare Kapazität einem festgelegten Schwellenwert der nutzbaren Kapazität entspricht,
- Trennen des genannten ausgewählten Moduls vom genannten Mittel zur variablen Entladung durch Öffnen des genannten Relais und
entweder Wiederaufladen des genannten ausgewählten Moduls durch Verbindung des genannten ausgewählten Moduls mit einem Batteriemodullademittel, wenn die genannte nutzbare Kapazität dem genannten festgelegten Schwellenwert entspricht
oder Erzeugung eines Signals, wenn die genannte nutzbare Kapazität dem genannten Schwellenwert nicht entspricht,
wobei
- die obigen Schritte vom genannten Steuergerät mit programmierbarer Logik koordiniert werden, das funktionsfähig in Kombination umfasst:
-- mindestens einen Spannungsableser,
-- mindestens einen Batteriestromableser und
-- mindestens einen Modulstromableser.

11. Verfahren gemäß Anspruch 10, in dem das Entladungsmittel das ausgewählte Modul bei einer festgelegten Ladung entlädt.

12. Verfahren gemäß Anspruch 10 oder 11, in dem das Entladungsmittel das ausgewählte Modul bei variablen Ladungen entlädt.

13. Verfahren gemäß mindestens einem der Ansprüche 10 bis 12, außerdem die Speicherung von Kapazitätsdaten mit Bezug auf die nutzbare Kapazität des ausgewählten Moduls umfassend.

14. Verfahren gemäß mindestens einem der Ansprüche 10 bis 13, außerdem die Bestimmung einer Kapazität anderer Module im Batteriesatz aus gespeicherten Kapazitätswerten anderer Module im Batteriesatz umfassend und das Wiederaufladen des ausgewählten Moduls durch Verbinden des ausgewählten Moduls mit dem Batteriemodullademittel, wobei das ausgewählte Modul auf einen Wiederaufladungswert aufgeladen wird, der mit der Kapazität anderer Module im Batteriesatz konsistent ist.

15. Verfahren gemäß mindestens einem der Ansprüche 10 bis 14, in dem das Entladungsmittel das mindestens eine Batteriemodul bei einer bestimmten Ladung entlädt.

16. Verfahren gemäß mindestens einem der Ansprüche 10 bis 15, in dem das Entladungsmittel das mindestens eine Batteriemodul bei variablen Ladungen entlädt.

## Revendications

1. Système
- pour évaluer directement la capacité utile d'au moins un module de batterie dans un set de batteries et/ou
- pour cycler des modules de batterie dans un set de batteries pendant que le set de batteries reste en service et/ou
- pour gestion de l'état de batteries de sets de batteries de réserve situées à distance,
système comprenant:
- un circuit de contrôle étant relié sur le plan opérationnel à un contrôleur logique programmable et à un ou plusieurs modules de batteries dans le set de batteries, le circuit de contrôle comprenant
-- des moyens de chargement du module de batterie
-- des moyens de déchargement, en particulier des moyens de déchargement pour décharger le module de batterie et
-- au moins un moyen de mesure de courant pour mesurer un courant de décharge et/ou un courant de charge du module de batterie qui existe au moins;
- le contrôleur logique programmable pour calculer des données par rapport à la capacité utile du module de batterie basé sur le courant du module de batterie qui existe au moins et
- une pluralité de relais étant contrôlés par le contrôleur logique programmable et étant connectés entre le circuit de contrôle et le set de batteries, en particulier étant couplés entre le moyen de chargement du module de batterie, le moyen de déchargement et les modules de batterie,
- le contrôleur logique programmable étant conçu pour contrôler le moyen de chargement du module de batterie et le moyen de déchargement et
- au choix et en particulier séquentiellement pour ouvrir et fermer la pluralité de relais qui relient avec le moyen de chargement de module de batterie et le moyen de déchargement,
-- pour coupler au moins un module de batterie dans le set de batteries au moyen de chargement du module de batterie ou au moyen de déchargement et/ou
-- pour, en variante, définir un circuit de déchargement qui permet à l'un des modules d'être déchargé par le moyen de déchargement et d'être rechargé par ledit moyen de chargement de module de batterie.

2. Système selon la revendication 1 dans lequel
- ledit contrôleur logique programmable est connecté par un lien de communication à un centre de données qui compile et traite des données transmises par ledit contrôleur logique programmable et
- des données par rapport à la capacité utile du module de batterie sont calculées par ledit contrôleur logique programmable et sont transmises audit centre de données.

3. Système selon la revendication 1 ou 2 comprenant de plus des moyens pour enregistrer lesdites données calculées par ledit contrôleur logique programmable.

4. Système selon au moins l'une des revendictaions 1 à 3 dans lequel lesdits relais sont sélectionnés dans le groupe comportant les relais multipolaires, contacteur ou les dispositifs de commutation monolithiques.

5. Système selon au moins l'une des revendications 1 à 4 dans lequel le moyen de déchargement pour décharger le module de batterie qui existe au moins comprend de plus un moyen pour décharger le module de batterie qui existe au moins sous une charge prédéfinie.

6. Système selon au moins l'une des revendications 1 à 5 dans lequel le moyen de déchargement pour décharger le module de batterie qui existe au moins comprend des moyens pour décharger de manière variable le module de batterie qui existe au moins.

7. Système selon au moins l'une des revendications 1 à 6 dans lequel le contrôleur logique programmable comprend:
- un contrôleur de commutation pour contrôler la pluralité de relais;
- un contrôleur pour le moyen de déchargement et
- un contrôleur pour le moyen de chargement du module de batterie.

8. Système selon au moins l'une des revendications 1 à 7 dans lequel le centre de données est un centre de contrôle principal qui fournit une pluralité de services comprenant l'assistance de monitorage et de diagnostic.

9. Système selon au moins l'une des revendications 1 à 8, **caractérisé par** l'augmentation de la capacité utile et/ou la réduction du taux de perte de capacité du set de batteries pendant le fonctionnement en utilisant un procédé de recharge optimal sur le module de batterie qui comprend ledit set de batteries tandis que ledit set de batteries reste en service, dans lequel la pluralité des différents procédés de rechargement est choisie dans le groupe comprenant:
a) la tension continue;
b) le courant continu;
c) la puissance continue;
d) la charge rapide;
e) le chargement d'impulsions.

10. Procédé pour évaluer de manière séquentielle la capacité utile d'une pluralité de modules de batteries qui définissent un set de batteries, le procédé comprenant les étapes de:
- fourniture d'un contrôleur logiques programmable comprenant un contrôleur pour contrôler l'ouverture et la fermeture de relais;
- sélection d'un des modules d'évaluation;
- connection du module sélectionné à un moyen de déchargement variable en fermant les relais qui connectent ledit module audit moyen de déchargement variable;
- mesure des paramètres de courant qui définissent la capacité utile dudit module pendant que ledit module est en charge;
- détermination du fait que ladite capacité utile est en rapport avec un seuil prédéfini pour la capacité utile;
- déconnexion dudit module sélectionné dudit moyen de déchargement variable en ouvrant lesdits relais et
soit recharge dudit module sélectionné en connectant ledit module sélectionné à un moyen de chargement de module de batterie lorsque ladite capacité utile est en rapport avec ledit seuil prédéfini
soit génération d'un signal lorsque ladite capacité utile n'est pas en rapport avec ledit seuil prédéfini;
dans lequel
- les étapes ci-dessus sont coordonnées par ledit contrôleur logique programmable comprenant sur le plan fonctionnel en combinaison
-- au moins un lecteur de tension;
-- au moins un lecteur de courant de batterie et
-- au moins un lecteur de module de courant.

11. Procédé selon la revendication 10 dans lequel le moyen de déchargement décharge le module sélectionné sous une charge prédéfinie.

12. Procédé selon la revendication 10 ou 11 dans lequel le moyen de déchargement décharge le module sélectionné sous des charges variables.

13. Procédé selon au moins l'une des revendications 10 à 12 comprenant de plus l'enregistrement des données de capacité concernant la capacité utile du module sélectionné.

14. Procédé selon au moins l'une des revendications 10 à 13 comprenant de plus la détermination d'une capacité d'autres modules dans le set de batteries à partir des données de capacité enregistrées d'autres modules dans le set de batteries et la recharge du module sélectionné en connectant le module sélectionné au moyen de chargement du module de batterie, le module sélectionné étant rechargé à un niveau de recharge compatible avec la capacité d'autres modules dans le set de batteries.

15. Procédé selon au moins l'une des revendications 10 à 14 dans lequel le moyen de déchargement décharge le module de batterie qui existe au moins sous une charge prédéfinie.

16. Procédé selon au moins au moins l'une des revendications 10 à 15 dans lequel le moyen de déchargement décharge le module de batterie qui existe au moins sous des charges variables.
